Europäisches Patentamt

European Patent Office

Office européen des brevets

(11) Publication number: **0 048 115**
**B1**

(12) # EUROPEAN PATENT SPECIFICATION

(45) Date of publication of patent specification: **25.06.86**

(51) Int. Cl.⁴: **H 03 M 7/00, H 03 K 19/195**

(21) Application number: **81304040.9**

(22) Date of filing: **04.09.81**

(54) Decoder circuit utilising Josephson devices.

(30) Priority: **12.09.80 JP 126871/80**
**12.09.80 JP 126872/80**

(43) Date of publication of application:
**24.03.82 Bulletin 82/12**

(45) Publication of the grant of the patent:
**25.06.86 Bulletin 86/26**

(84) Designated Contracting States:
**DE FR GB**

(56) References cited:
**GB-A-1 441 509**
**US-A-4 097 765**

**IEEE JOURNAL OF SOLID-STATE CIRCUITS,**
**vol. Sc-14, no. 4, August 1978, pages 699-707,**
**New York, U.S.A., S.M. FARIS: "Loop decoder**
**for Josephson memory arrays"**

**IBM TECHNICAL DISCLOSURE BULLETIN, vol.**
**21, no. 11, April 1979, pages 4699-4701, New**
**York, U.S.A., S.M. FARIS: "Multiplexing with**
**functional loop logic"**

**IBM TECHNICAL DISCLOSURE BULLETIN, vol.**
**21, no. 6, November 1978, pages 2538-2540,**
**New York, U.S.A., A. MOSER: "Josephson**
**junction loop decoder with self-resetting and**
**gates"**

(73) Proprietor: **FUJITSU LIMITED**
**1015, Kamikodanaka Nakahara-ku**
**Kawasaki-shi Kanagawa 211 (JP)**

(72) Inventor: **Hasuo, Shinya**
**157-8, Ohba-cho Midori-ku**
**Yokohama-shi Kanagawa 227 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:

**IBM TECHNICAL DISCLOSURE BULLETIN, vol.**
**4, no. 7, December 1961, pages 48-49, New**
**York, u.s.A., L. SMITH et al.: "Memory**
**addressing circuitry"**

Courier Press, Leamington Spa, England.

## Description

This invention relates to a decoder circuit utilising Josephson devices.

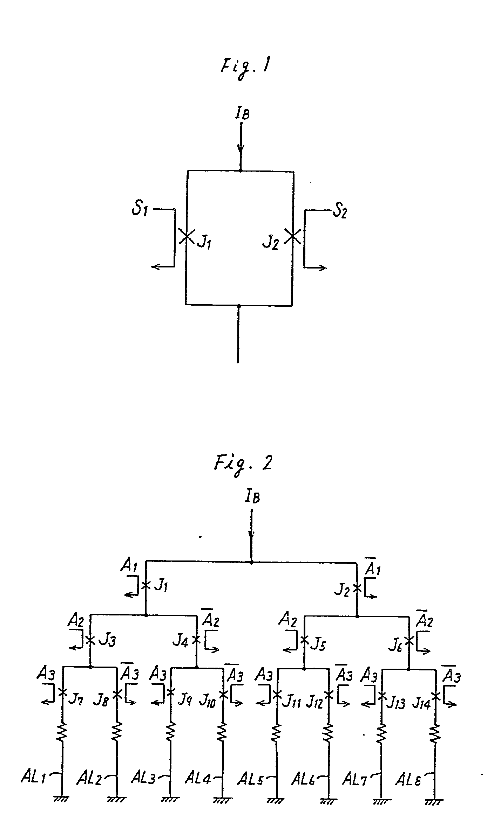

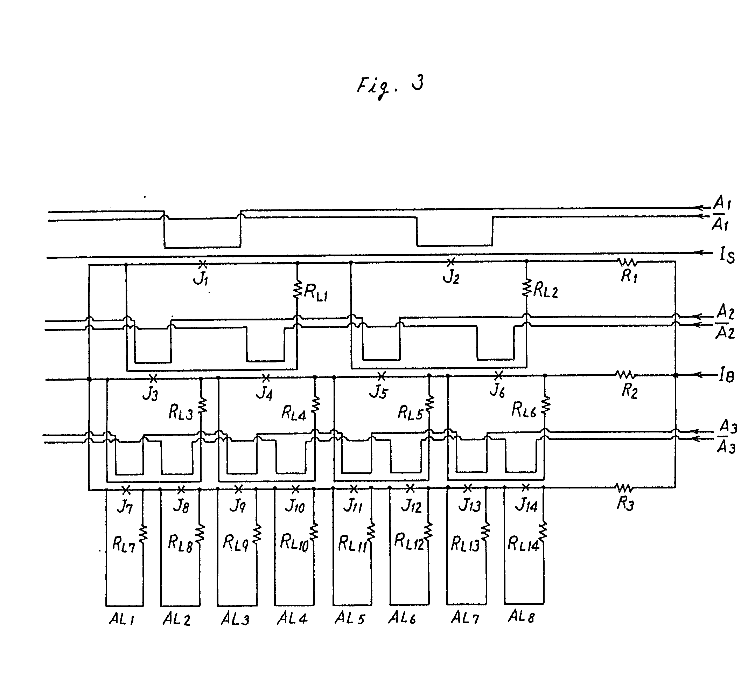

There are several kinds of existing decoders for Josephson memory circuits. However, all such decoders are composed basically of a combination of current flip-flop circuits. One example of such a current flip-flop circuit is illustrated in Figure 1 of the accompanying drawings. In the current flip-flop of Figure 1, when an input signal current $S_1$ is supplied to a Josephson junction $J_1$, on the left side of Figure 1, whilst a bias current $I_B$ is flowing through the Josephson junction, the junction $J_1$ momentarily achieves a voltage state and the bias current $I_B$, substantially, flows through the junction $J_2$ on the right side of Figure 1. When an input current $S_2$ is applied, on the other hand, to the junction $J_2$, on the right side of Figure 1, the bias current $I_B$, substantially flows through the left side junction $J_1$. In any event, the junctions $J_1$, $J_2$ are connected in parallel and when one is in the voltage state, the other is in a supercurrent state. Therefore, the one is returned to the supercurrent state, but the current path is still switched. A combination of such current flip-flops is used to provide a so-called tree decoder as shown in Figure 2 of the accompanying drawings, which is described in the IEEE Journal of Solid State Circuitry, Volume SC-13, No. 5, pages 591 to 600, 1978, by W. H. Henkels and H. Zappe.

The circuit shown in Figure 2 is an example of an eight-bit address decoder, in which current flows in one of the address lines $AL_1$ to $AL_8$ in dependence upon three-bit input signals $A_1$, $A_2$, $A_3$. For example, when the address bit $A_1$ is 1, the junction $J_1$ becomes ON (voltage state) and current $I_B$ flows in the circuit branch including junction $J_2$. When the address bit $A_2$ is 0, the inverted address bit $\bar{A}_2$ is 1, and therefore the junction $J_6$ becomes ON, causing the current $I_B$ to flow into the circuit branch including the junction $J_5$. Moreover, when the address bit $A_3$ is 1, the junction $J_{11}$ becomes ON and the current $I_B$ flows in the address line $AL_6$ including junction $J_{12}$ (that is, $AL_6$ is selected). Thus, a desired single address line can be selected from amongst 2n address lines in dependence upon an $n$-bit input signal.

Another type of decoder circuit, a loop decoder, is proposed in the IEEE Journal of Solid State Circuitry, Volume SC-14, No. 4, pages 699 to 707, 1979, by S. Faris.

These decoder circuits are all composed of combinations of current flip-flop circuits or modified circuits.

However, a current flip-flop is loaded by the superconducting loop inductance from the point of view of the Josephson junction. For this reason, such decoder circuits have a disadvantage in that as address lines $AL_1$ to $AL_8$ become longer, longer switching periods are required for the branch circuit for current $I_B$. In practice, such a switching period is of the order of nanoseconds and a decoder circuit utilising such current flip-flops cannot utilise to advantage the high speed characteristics (tens of picoseconds) offered by Josephson devices.

IBM Technical Disclosure Bulletin, Vol. 21, No. 6, November 1978, Pages 2538 and 2540, in an article by Moser entitled "Josephson junction loop decoder with self resetting AND gates" discloses a decoder said to use self-resetting two input AND gates. It is apparent, however, that the decoder employs flip-flop arrangements having AND'ed inputs. Figure 2 of this article shows a three-to-eight bit decoder for processing address information A, B, C, in three logic stages.

The second logic stage has four ($2^2$) such Josephson AND gates whilst the third logic stage has eight ($2^3$) such AND gates. The first stage has address loops each controlling two flip-flops which provide the address information in true (A, B, C) and complementary ($\bar{A}$, $\bar{B}$, $\bar{C}$,) form.

The second stage combines true and complementary address information (A, B) and ($\bar{A}$, $\bar{B}$) to provide four logical products ($\bar{A}.\bar{B}$, A.$\bar{B}$, $\bar{A}$.B, A.B). The third stage combines these products with the remaining address information (C, $\bar{C}$) to form further logical products.

According to the present invention, there is provided a decoder circuit comprising Josephson devices, having $m$ switching stages (where $m$ is a whole number greater than unity), the nth switching stage (where $n$ is a whole number of greater than unity and less than or equal to $m$) comprising $2^n$ Josephson AND gates, each AND gate comprising a Josephson device, operating with a latch operation, having an output line connected to opposite ends of the Josephson device and including a load resistor matched to the characteristic impedance of the line, and at least one input signal line, and being operable to be switched ON or OFF, for the passage of current through the output line, in dependence upon the logical product of current flowing through the output line of an AND gate of the $(n$-1)th stage and the current or currents flowing through the said at least one input signal line.

An embodiment of the present invention can provide a decoder circuit which offers high speed operation.

An embodiment of the present invention can provide a decoder circuit which has a reduced number of wirings and as a result is suitable for realisation of a higher integration density.

A decoder circuit embodying the present invention has a structure in which a number of stages are provided, the $n$th stage having 2n Josephson AND gates, each comprising a Josephson device, an output line connected to opposite ends of the Josephson device, and an input signal line, each gate becoming ON in dependence upon the logical product (AND) of the current flowing in the output line of a Josephson device of a preceding stage, or the current flowing in a decoding start line, and the input signal current flowing in the input signal line of the gate, for passing current through the output line of the gate.

Reference is made, by way of example, to the accompanying schematic drawings, in which:—

Figure 1 illustrates the equivalent circuit of a current flip-flop utilising Josephson devices,

Figure 2 illustrates the equivalent circuit of an existing tree decoder circuit utilising current flip-flops as shown in Figure 1,

Figure 3 illustrates an embodiment of the present invention, and

Figure 4 illustrates another embodiment of the present invention.

Figure 3 illustrates the equivalent circuit of an embodiment of the present invention, in which circuit one of address lines $AL_1$ to $AL_8$ is selected in dependence upon the values of three-bit input signals $A_1$ to $A_3$. In this example, circuits in which Josephson devices having each a two input AND function are serially connected are provided in three stages; a first stage including two devices $J_1$, $J_2$, a second stage including four devices $J_3$ to $J_6$, and a third stage including eight devices $J_7$ to $J_{14}$.

In the first stage, the input signal $\bar{A}_1$ is applied to device $J_1$ whilst the inverted signal $A_1$ (the inverse of signal $A_1$—$A_1$'s complement) is applied to device $J_2$. Moreover, a signal $I_s$, for starting decoding, is applied in common to the devices $J_1$ and $J_2$.

An output of device $J_1$ is applied to devices $J_3$ and $J_4$ of the second stage, whilst an output of the device $J_2$ is applied to the devices $J_5$ and $J_6$ of the second stage.

In the second stage, the input signal $A_2$ is applied to devices $J_3$ and $J_5$, whilst the complement $\bar{A}_2$ is applied to devices $J_4$ and $J_6$.

In the third stage, an output of the device $J_3$ is applied to devices $J_7$, $J_8$, whist an output of device $J_4$ is applied to the devices $J_9$, $J_{10}$, an output of device $J_5$ is applied to the devices $J_{11}$, $J_{12}$, and an output of device $J_6$ is applied to devices $J_{13}$, $J_{14}$.

In the third stage, the input signal $A_3$ is applied to devices $J_7$, $J_9$, $J_{11}$ and $J_{13}$, whilst its complement $\bar{A}_3$ is applied to devices $J_8$, $J_{10}$, $J_{12}$ and $J_{14}$.

These devices $J_1$ to $J_{14}$ are respective two-input Josephson AND gates which become ON (voltage state) only when the two inputs are both 1.

The resistors $R_{L1}$ to $R_{L14}$ in Figure 3 are load resistors, and $R_1$ to $R_3$ are bias current dividing resistors.

In this example, as bias power supply, a desired bias current is supplied in common to each stage through the resistors $R_1$ to $R_3$. However, the bias can be changed as desired. For example, bias power supply may be provided for each respective stage.

Operations when $(A_1, A_2, A_3)=(1, 0, 1)$ will be explained below.

When these input signal values are supplied, and the decoding start signal $I_s$ is applied, the device $J_1$ is first switched to the voltage state (ON) when $A_1=1$, $I_s=1$ and an output is applied from $J_1$ to devices $J_3$ and $J_4$ in the second stage. At this time, since $\bar{A}_2=1$, the device $J_4$ is switched ON in the second stage, and an output thereof is applied to devices $J_9$ and $J_{10}$ in the third stage. As a result,

the device $J_9$, which receives the said output and the signal $A_3=1$, is switched ON and thereby only the address line $AL_3$ is selected. In the above operations, it is important that the devices $J_1$ to $J_{14}$ all operate with a latch operation, and do not operate in the form of current flip-flops. Therefore, the resistance value of load resistors $R_{L1}$ to $R_{L14}$ matches the characteristic impedance of wirings, and outstandingly high-speed selection of address lines $AL_1$ to $AL_8$ can be realised (improvement of speed of operation by one digit can be realised as compared with the speed of operation with current flip-flops).

Although power consumption is certainly increased due to the use of latch operations, such increase in power consumption is so small as to be negligible for practical purposes, because only $n$ ON gates actually consume power.

In the above embodiment of the present invention, the decoding start signal $I_s$ is externally applied, but such a start signal can alternatively be obtained by branching the bias current $I_B$ to provide the start signal line, and as a further alternative the signal $I_s$ can be omitted entirely if device $J_1$ (and possibly also device $J_2$) of the first stage is formed as an OR gate.

In the above embodiment of the present invention, the devices in each stage are connected in series in the stage, but they can alternatively be connected in parallel by dividing the bias current $I_B$. Furthermore, even in the case in which serial connection is used, it is desirable to insert resistors between elements with a view to realising reliable operation of elements.

For each of the devices $J_1$ to $J_{14}$, any discrete junction element, two-junction quantum interference device or three-junction quantum interference device may be employed, so long as it plays a role providing a two-input AND junction.

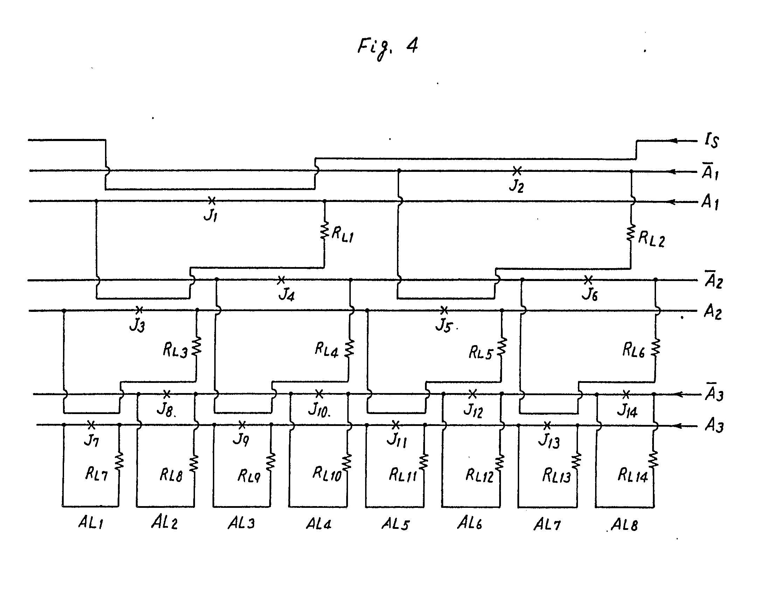

Figure 4 shows the equivalent circuit of another embodiment of the present invention, which is an example of a circuit in which a selection from amongst eight address lines $AL_1$ to $AL_8$ is made in dependence upon three-bit extrenal input signals $A_1$ to $A_3$. In this embodiment of the present invention, the circuit has a three stage staircase structure.

In the first stage, two latch-type AND circuits (Josephson devices) $J_1$, $J_2$ are provided, whilst four devices $J_3$ to $J_6$ are provided in the second stage, and eight devices $J_7$ to $J_{14}$ provided in the third stage. Thus, fourteen devices are provided in all. Each device is a two-input AND circuit which receives an output of a device of a preceding stage (or a signal $I_s$ if the device is in the first stage) as an internal input signal, and which also receives an external input signal $A_1$ to $A_3$. The complements $\bar{A}_1$ to $\bar{A}_3$ and input signals $A_1$ to $A_3$ are used as bias currents. Each AND gate switches to the ON (voltage) state when both inputs thereof are 1. Namely, the external input signal $A_1$ causes a bias current flow into the Josephson device $J_1$, and $A_1$'s complement $\bar{A}_1$ causes a bias current to flow into the devices $J_2$. The external input signal $A_2$ of the second stage causes a bias current to flow into the devices $J_3$, $J_5$, whilst the complement $\overline{A}_2$ causes a bias current to flow into the devices $J_4$, $J_6$. In the same way, the external input signal $A_3$ of the third stage causes a bias current to flow into the devices $J_7$, $J_9$, $J_{11}$, $J_{13}$, whilst the complement $\overline{A}_3$ causes a bias current to flow into the devices $J_8$, $J_{10}$, $J_{12}$ and $J_{14}$.

On the other hand, an output of the device $J_1$ is applied to the devices $J_3$, $J_4$, whilst an output of the device $J_2$ is applied to devices $J_5$, $J_6$, respectively, as internal input signals. Similarly, an output of the device $J_3$ is applied to devices $J_7$, $J_8$ of the next stage, whilst an output of the device $J_4$ is applied to the devices $J_9$, $J_{10}$, an output of the device $J_5$ is supplied to the devices $J_{11}$, $J_{12}$, and an output of the device $J_6$ is applied to the devices $J_{13}$, $J_{14}$, respectively, as intenral input signals. Since no output of a device of a preceding stage is applied to devices $J_1$ and $J_2$ of the first stage signal current $I_S$ for starting decoding is applied to $J_1$ and $J_2$.

Operations when the external input signals $A_1=1$, $A_2=0$, $A_3=1$, for example, are supplied, will be explained below.

When $I_S=1$ is applied, after the external input $A_1$ to $A_3$ are applied as indicated above the device $J_1$, whose two inputs $A_1$ and $I_S$ are 1, is switched ON, outputting a signal to the devices $J_3$, $J_4$ of the next stage. At this time, since $A_2=0$, and as a result $\overline{A}_2=1$, the device $J_4$ turns to the voltage state. In addition, an output of the device $J_4$ is applied to the devices $J_9$ and $J_{10}$ of the third stage, and since $A_3=1$, the device $J_9$ switches, and as a result only the address line $AL_3$ including a load resistor $R_{L9}$, is selected.

Each gate used in the embodiment of Figure 4 switches only when both the bias current (here provided by an external input signal $A_1$ to $A_3$ or a complement thereof) and the input signal current (signal $I_S$ or an output of a preceding stage) are applied simultaneously thereto, and moreover the gate performs a latch operation. The characteristic impedance of interconnection is matched to load resistors $R_{L1}$ to $R_{L14}$ and thereby an improvement in speed characteristic of about one order of magnitude as compared with existing decoder circuits is expected.

For devices $J_1$ to $J_{14}$, not only discrete junction devices can be used, but also, two-junction quantum interference devices or three-junction quantum interference devices, namely any Josephson device which performs a AND function between a bias current and an input signal, may be used.

Moreover, the decoding start signal $I_S$ can be omitted if the devices $J_1$, $J_2$ of the first stage are designed to be switched with the bias current.

The Josephson junctions connected in series in each stage in the embodiment of Figure 4 may alternatively be connected in parallel. However, in the case of parallel connection, external input signal currents must be greater than those required in the case of serial connection by a factor equal to the number of parallel connections. Therefore, the signal circuit must have a large driving capability.

As explained above, an embodiment of the present invention can provide an advantage in that a circuit can be formed with strip lines terminated by matching impedances, because latch type Josephson AND gates are used, and, moreover, a high speed decoder circuit can be realised.

In particular, the embodiment of the present invention described with reference to Figure 4 is superior in that a high integration density of circuitry elements can be obtained because one of the two inputs to each AND gate is the bias current to be supplied to the Josephson junction and therefore only one signal line is required for field coupling to the junction and as a result a lesser number of wirings is required.

An embodiment of the present invention provides a decoder circuit utilising Josephson devices. A $n$th stage of the decoder has $2^n$ Josephson AND gates. Each AND gate consists of a Josephson device, with an output line connecting both terminals of the Josephson device, and with an input signal line. Each Josephson AND gate turns ON in dependence upon the logical product (AND) of the current flowing into the output line of a Josephson AND gate of a preceding stage and the current flowing into the input signal line of the pertinent stage and causes a current to flow into the output line.

An embodiment of the present invention provides a decoder circuit utilising the Josephson device comprising; the $2^n$-Josephson AND gates provided in the $n$th stage, each of said Josephson AND gate provides a Josephson device, an output line connecting both ends of said Josephson device, and at least one input signal line, wherein said Josephson AND gate becomes ON with the logical product (AND) of the current flowing through said output line of the Josephson AND gate of the preceding stage and the current flowing through the input signal line of the pertinent stage, thus outputting a current to said output line of pertinent stage.

Such a decoder circuit may be arranged so that the current flowing through said input signal line flows into said Josephson device.

**Claims**

1. A decoder circuit comprising Josephson devices, having $m$ switching stages (where $m$ is a whole number greater than unity), the nth switching stage (where $n$ is a whole number greater than unity and less than or equal to $m$) comprising $2^n$ Josephson AND gates, each AND gate comprising a Josephson device, operating with a latch operation, having an output line connected to opposite ends of the Josephson device and including a load resistor matched to the characteristic impedance of the line, and at least one input signal line, and being operable to be switched ON or OFF, for the passage of current through the output line, in dependence upon the logical product of current flowing through the output line of an AND gate of the $(n$-1)th stage and the current or currents flowing through the said at least one input signal line.

2. A decoder circuit as claimed in claim 1, wherein a first switching stage comprises two Josephson AND gates, each of those AND gates comprising a Josephson device, operating with a latch operation, having an output line connected to the opposite ends of the Josephson device and including a load resistor matched to the characteristic impedance of the line, and having at least one input signal line, and being operable to be switched ON or OFF, for the passage of current through the output line, in dependence upon the logical product of current flowing through a signal line for starting decoding, and the current or currents flowing through the said at least one input signal line.

3. A decoder as claimed in claim 1 or 2, wherein the or one of the input signals lines of each AND gate is a line for supplying bias current through the Josephson device of the AND gate.

4. A decoder as claimed in claim 1, wherein a first switching stage comprises two Josephson OR gates, each of those OR gates comprising a Josephson device, having an output line connected to opposite ends of the Josephson device and at least one input signal line, and being operable to be switched ON or OFF, for the passage of current through the output line, in dependence upon current flowing through the input signal line or the logical sum of currents flowing through each input signal line.

5. A decoder as claimed in claim 3, when read as appendant to claim 1, wherein a first switching stage comprises two Josephson gates, each of those gates comprising a Josephson device, having an output line connected to opposite ends of the Josephson device, and being operable to be switched ON or OFF for the passage of current through the output line, in dependence upon the supply of bias current to the Josephson device.

6. A decoder as claimed in any one of claims 1 to 5, wherein in each respective stage, Josephson devices are connected in series for receiving bias current therefor.

7. A decoder as claimed in any one of claims 1 to 5, wherein, in each respective stage, Josephson devices are connected in parallel for receiving bias current therefor.

8. A decoder as claimed in any preceding claim, wherein the AND gates of the decoder are two-input AND gates.

**Patentansprüche**

1. Decodierschaltung mit Josephson-Einrichtungen, mit $m$-Schaltstufen (wobei $m$ eine ganze Zahl größer als eins ist), die n-te-Schaltstufe (wobei $n$ eine ganze Zahl größer als eins und kleiner oder gleich $m$ ist) $2^n$ Josephson-UND-Glieder umfaßt, jedes UND-Glied eine Josephsoneinrichtung umfaßt, die mit einem Haltebetrieb arbeitet, eine Ausgangsleitung hat, die mit entgegengesetzten Enden der Josephson-einrichtung verbunden ist und einen Lastwiderstand einschließt, der an die Impedanzcharakteristik der Leitung angepaßt ist, und wenigstens eine Eingangssignalleitung, und im Betrieb, für den Durchgang eines Stromes durch die Ausgangsleitung, EIN oder AUS geschaltet werden kann, in Abhängigkeit von dem logischen Produkt eines Stromes, der durch die Ausgangsleitung eines UND-Gliedes der $(n$-1)-ten Stufe fließt, und des Stromes oder der Ströme, die durch die genannte wenigstens eine Eingangsleitung fließen.

2. Decodierschaltung nach Anspruch 1, bei welcher eine erste Schaltstufe zwei Josephson-UND-Glieder umfaßt, von denen jedes UND-Glied eine Josephson-Einrichtung umfaßt, die mit einem Haltebetrieb arbeitet, eine Ausgangsleitung hat, die mit entgegengesetzten Enden der Josephson-Einrichtung verbunden ist und einen Lastwiderstand umfaßt, der an die Impedanzcharakteristik der Leitung angepaßt ist, und wenigstens eine Eingangssignalleitung hat und im Betrieb, für den Durchgang des Stromes durch die Ausgangsleitung, EIN oder AUS geschaltet werden kann, in Abhängigkeit von dem logischen Produkt des Stromes, der durch eine Signalleitung fließt, für den Beginn der Decodierung, und des Stromes oder der Ströme, die durch die genannte wenigstens eine Eingangsleitung fließen.

3. Decoder nach Anspruch 1 oder 2, bei welchem die oder eine der Eingangsleitungen von jedem UND-Glied eine Leitung zur Zuführung eines Vorspannungsstromes durch die Josephson-Einrichtung des UND-Gliedes ist.

4. Decoder nach Anspruch 1, bei welchem eine erste Schaltstufe zwei Josephson-ODER-Glieder umfaßt, von denen jedes ODER-Glied eine Josephson-Einrichtung umfaßt, die eine Ausgangsleitung hat, die mit entgegengesetzten Enden der Josephson-Einrichtung und wenigstens einer Eingangsleitung verbunden ist, und die im Betrieb, für den Durchgang eines Stromes durch die Ausgangsleitung, EIN oder AUS geschaltet werden kann, in Abhängigkeit von einem Strom, der durch die Eingangssignalleitung fließt, oder der logischen Summe von Strömen, die durch jede Eingangssignalleitung fließen.

5. Decoder nach Anspruch 3, in Verbindung mit Anspruch 1, bei welcher eine erste Schaltstufe zwei Josephson-Glieder umfaßt, von denen jedes Glied ein Josephson-Einrichtung umfaßt, die eine Ausgangsleitung hat, die mit entgegengesetzten Enden der Josephson-Einrichtung verbunden ist, und die im Betrieb, für den Durchgang des Stromes durch die Ausgangsleitung, EIN oder AUS geschaltet werden kann, in Abhängigkeit von der Zuführung des Vorspannungsstromes zu der Josephson-Einrichtung.

6. Decoder nach einem der Ansprüche 1 bis 5, bei welchem in jeder entsprechenden Stufe Josephson-Einrichtungen zum Empfang des Vorspannungsstromes in Reihe geschaltet sind.

7. Decoder nach einem der Ansprüche 1 bis 5, bei welchem in jeder entsprechenden Stufe Josephson-Einrichtungen parallel zur Empfang des Vorspannungsstromes geschaltet sind.

8. Decoder nach einem der vorhergehenden Ansprüche, bei welcher UND-Glieder des Decoders UND-Glieder mit zwei Eingängen sind.

**Revendications**

1. Circuit décodeur comprenant des dispositifs Josephson, possédant $m$ étages de commutation (où $m$ est un nombre entier supérieur à l'unité), le $n^{ième}$ étage de commutation (où $n$ est un nombre entier supérieur à l'unité et inférieur ou égal à $m$) comprenant $2^n$ portes ET Josephson, chaque porte ET comprenant un dispositif Josephson, fonctionnant avec une opération de verrouillage, possédant une ligne de sortie connectée aux extrémités opposées du dispositif Josephson et comportant une résistance de charge adaptée à l'impédance caractéristique de la ligne, et au moins une ligne de signal d'entrée, et pouvant être amené à commuter "en circuit" ou "hors circuit", quant au passage du courant dans la ligne de sortie, selon la produit logique du courant passant dans la ligne de sortie d'une porte ET du $(n-1)^{ième}$ étage et du ou des courant(s) passant dans ladite ou lesdites ligne(s) du signal d'entrée.

2. Circuit décodeur selon la revendication 1, où un premier étage de commutation comprend deux portes ET Josephson, chacune de ces portes ET Josephson comprenant un dispositif Josephson, fonctionnant avec une opération de verrouillage, ayant une ligne de sortie connectée aux extrémités opposées du dispositif Josephson et comportant une résistance de charge adaptée à l'impédance caractéristique de la ligne et possédant au moins une ligne de signal d'entrée, et pouvant être amené à commuter "en circuit" ou "hors circuit", quant au passage du courant dans la ligne de sortie, selon le produit logique du courant passant dans une ligne de signal servant à faire débuter le décodage et du ou des courant(s) passant dans ladite ou lesdites ligne(s) de signaux d'entrée.

3. Décodeur selon la revendication 1 ou 2, où la ligne ou une des lignes de signaux d'entrée de chaque porte ET est une ligne servant à délivrer un courant de polarisation à travers le dispositif Josephson de la porte ET.

4. Décodeur selon la revendication 1, où un premier étage de commutation comprend deux portes OU Josephson, chacune de ces portes OU comprenant un dispositif Josephson, possédant une ligne de sortie connectée aux extrémités opposées du dispositif Josephson et au moins une ligne de signal d'entrée, et pouvant être amené à commuter "en circuit" ou "hors circuit", quant au passage du courant dans la ligne de sortie, selon la courant passant dans la ligne de signal d'entrée ou la somme logique des courants passant dans chaque ligne de signal d'entrée.

5. Décodeur selon la revendication 3, lue en dépendance avec la revendication 1, où un premier étage de commutation comprend deux portes Josephson, chacune de ces portes comprenant un dispositif Josephson, ayant une ligne de sortie connectée aux extrémités opposées du dispositif Josephson, et pouvant être amené à commuter "en circuit" ou "hors circuit", quant au passage du courant dans la lignes de sortie, selon l'alimentation en courant de polarisation fournie au dispositif Josephson.

6. Décodeur selon l'une quelconque des revendications 1 à 5, où, dans chaque étage respectif, des dispositifs Josephson sont connectés en série afin de recevoir un courant de polarisation.

7. Décodeur selon l'une quelconque des revendications 1 à 5, où, dans chaque étage respectif, des dispositifs Josephson sont connectés en parallèle afin de recevoir un courant de polarisation.

8. Décodeur selon l'une quelconque des revendications précédentes, où les portes ET du décodeur sont des portes ET à deux entrées.

Fig. 1

Fig. 2

Fig. 3

Fig. 4

$I_S$

$\overline{A}_1$

$J_2$

$A_1$

$J_1$

$R_{L1}$

$R_{L2}$

$\overline{A}_2$

$J_4$

$J_6$

$J_3$

$A_2$

$J_5$

$R_{L3}$

$R_{L4}$

$R_{L5}$

$R_{L6}$

$\overline{A}_3$

$J_8$

$J_{10}$

$J_{12}$

$J_{14}$

$A_3$

$J_7$

$J_9$

$J_{11}$

$J_{13}$

$R_{L7}$

$R_{L8}$

$R_{L9}$

$R_{L10}$

$R_{L11}$

$R_{L12}$

$R_{L13}$

$R_{L14}$

$AL_1$  $AL_2$  $AL_3$  $AL_4$  $AL_5$  $AL_6$  $AL_7$  $AL_8$